# EUROPEAN PATENT SPECIFICATION

(11) **EP 4 208 715 B1**
(45) Date of publication and mention of the grant of the patent: **04.11.2026**
(21) Application number: 21720556.6
(22) Date of filing: 03.03.2021
(51) Int. Cl.: G01N 29/02, G01N 29/22, G01N 29/24, G01K 11/26, H03H 9/02

(54) **SURFACE ACOUSTIC WAVE SENSOR DEVICE FORMED ON A QUARTZ SUBSTRATE**
AKUSTISCHE OBERFLÄCHENWELLEN-SENSORANORDNUNG AUF EINEM QUARZSUBSTRAT
SURFACE ACOUSTIC WAVE SENSOR DEVICE FORMED ON A QUARTZ SUBSTRATE

(30) Priority: 04.09.2020 WO PCT/EP2020/074865
(43) Date of publication of application: 12.07.2023
(73) Proprietor: SOITEC, 38190 Bernin (FR)
(72) Inventor: BALLANDRAS, Sylvain, 25000 Besançon (FR); LAROCHE, Thierry, 25000 Besançon (FR); GARCIA, Julien, 39380 Chamblay (FR); COURJON, Emilie, 25770 Franois (FR); BERNARD, Florent, 25000 Besançon (FR)
(74) Representative: Grünecker Patent- und Rechtsanwälte PartG mbB
(86) International application number: PCT/IB2021/000128
(87) International publication number: WO 2022/049418

(56) References cited:
- EP-A1- 0 998 037
- EP-A1- 2 418 482
- EP-A1- 2 799 860
- EP-A1- 2 871 474
- CN-B- 104 768 113
- JP-A- 2007 142 794
- US-A- 5 221 870
- US-A1- 2006 049 714
- SCHWELB O: "AXIAL MODES OF ACOUSTICALLY COUPLED SURFACE ACOUSTIC WAVE FABRY- PEROT RESONATORS", JOURNAL OF APPLIED PHYSICS, AMERICAN INSTITUTE OF PHYSICS, US, vol. 68, no. 2, 15 July 1990 (1990-07-15), pages 474 - 481, XP000436494, ISSN: 0021-8979, DOI: 10.1063/1.347185

## Description

The present invention relates to sensors of the acoustic wave type and, in particular, a surface acoustic wave sensor device comprising a transducer and reflection structures formed over a quartz substrate.

Sensors are of growing importance and become more and more ubiquitous in every-day life. Microelectromechanical systems (MEMS) are an attractive option to answer the demand for increased performances of sensors along with decreased sizes and costs. Surface acoustic wave (SAW) sensors, and to a lower extent bulk acoustic wave (BAW) sensors or Lamb wave or Love wave acoustic sensors, offer particularly advantageous options due to a wide variety of measurable ambient parameters including temperature, pressure, strain and torque, for example.

Acoustic wave sensors utilize the piezoelectric effect to transduce an electrical signal into a mechanical / acoustic wave. SAW-based sensors are built on single-crystal piezoelectric materials like quartz (SiO₂), lithium niobate (LiNbO₃), lithium tantalate (LiTaO₃), langasite (LGS) or poly-crystal piezoelectric materials like aluminum nitride (AIN) or zinc oxide (ZnO), in particular, deposited on silicon, or even on a Piezo-On-Insulator (POI) composite material comprising a layer of piezoelectric material, in particular, a single-crystal material, such as, for example, lithium tantalate or lithium niobate, bonded to a support substrate as for instance silicon, if necessary by means of a bonding layer, as for instance a silicon oxide layer (in general, any combination of a single crystal piezoelectric material with non-piezoelectric substrates can be used in view of their specific properties like thermo-elastic properties or acoustic quality).

In the case of a surface acoustic wave sensor, an interdigitated transducer (IDT) converts the electrical energy of the electrical signal into acoustic wave energy. The acoustic wave travels across the surface (or bulk) of a device substrate via the so-called delay line to another transducer, in particular, an IDT, that converts the acoustic wave back to an electrical signal that can be detected. In some devices, mechanical absorbers and/or reflectors are provided in order to prevent interference patterns and to reduce insertion loss. In some devices, the other (output) IDT is replaced by a reflector that reflects the generated acoustic wave back to the (input) IDT that can be coupled to an antenna for remote interrogation of the sensor device. Advantageously, the measurements can be performed completely passively, i.e., the sensor has not to be powered by a power source.

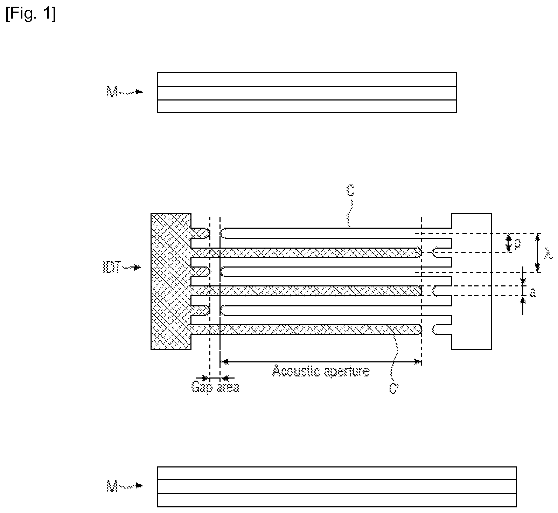

A particular class of acoustic wave sensors comprises resonators exhibiting resonance frequencies that vary according to varying ambient conditions. Figure 1 illustrates an example of a resonant acoustic wave sensor. The surface acoustic wave resonator comprises an electroacoustic interdigitated transducer IDT with interdigitated comb electrodes C and C' arranged between Bragg mirrors M. The comb electrodes are set at opposite potentials +V and -V, respectively. The electrode geometry is defined by the pitch p, i.e., the spatial repetition frequency of the interleaved electrodes C and C' in the direction of the propagation of the excited surface acoustic waves, the lengths of the gaps between the electrodes C and C' in the direction perpendicular to the direction of the propagation of the excited surface acoustic waves, the lengths of the acoustic aperture region given by the lengths of the electrodes C and C' between the gaps and the widths a of the electrodes C and C' determining the so-called metalization ratio a/p. The IDT can operate at Bragg conditions at which the wavelength λ of the excited surface acoustic wave equals twice the pitch p, for example.

At the resonance frequency, the condition of synchronism between the reflectors is satisfied thereby allowing for a coherent addition of the different reflections which occur under the reflectors. A maximum of acoustic energy is observed within the resonant cavity and, from an electrical point of view, a maximum of amplitude of the current admitted by the transducer is observed. In principle, differential acoustic wave sensors may comprise two or more resonators exhibiting different resonance frequencies or a resonator working in multimode (several resonance frequencies), wherein differences in the measured frequencies reflect variations in the ambient parameters that is to be measured (the measurand) as, for example, temperature, pressure or strain.

However, despite the recent engineering progress, the entire interrogation process wherein an interrogator transmits an appropriate radio-frequency (RF) signal that is received by the acoustic wave sensor via a reception antenna and converted by a transducer into a surface acoustic wave (or bulk wave, in the case of devices of a bulk acoustic wave sensor type) that is converted into a RF signal being re-transmitted via an emission antenna and received and analyzed by the interrogator still poses demanding technical problems.

US 2006/049714 A1 discloses a surface acoustic wave chemical sensor comprising two transducer-reflectors structures as illustrated in Figure 1 and described in paragraphs 19 to 28. An absorptive material layer is selectively formed on one of the resonance areas of each of the transducer-reflectors structures, respectively.

EP 0 998 037 A1 discloses employment of a quartz crystal cut for a surface acoustic wave device with a broad parameter range given by ϕ= -60° to 0°, θ = -40° cos (3 ϕ) +- 40° and ψ = (35° + 10 sin (3 ϕ)) +- 22.5°.

EP 2 871 474 A1 discloses a surface acoustic wave sensor comprising a Fabry-Perot type resonator.

True differential measurements based on appropriate differential sensitivities of the resonances of the resonator(s) used to the measurand have to be accurately observed in order to obtain reliable measurement results. This poses severe demands for tolerances of the production processes and reproducibility of physical properties from one wafer to another. In addition, any relative motion between the sensor device and the interrogator can heavily affect the measurement results due to the RF link formed by the sensor device and the interrogator in an inductive, capacitive or radiative manner. Other environmental influences, for example, temperature changes, in the measurement environment also affect the reliability of the measurement results.

Therefore, it is an object of the present invention to provide an acoustic wave sensor that allows for an increased signal-to-noise ratio and more reliable measurement results as compared to the acoustic wave sensor devices of the art.

The present invention addresses the above-mentioned object by providing an acoustic wave sensor device, for example, a surface acoustic wave sensor device, comprising a Si bulk substrate or a sapphire bulk substrate;
a quartz material layer comprising a planar surface and formed over the Si bulk substrate or the sapphire bulk substrate;
a first interdigitated transducer formed over the planar surface of the quartz material layer;
a first reflection structure formed over the planar surface of the quartz material layer;
a second reflection structure formed over the planar surface of the quartz material layer;
a first resonance cavity formed between the first interdigitated transducer and the first reflection structure; and
a second resonance cavity formed between the first interdigitated transducer and the second reflection structure;
wherein the planar surface of the quartz material layer is defined by a crystal cut of a quartz material of the quartz material layer with angles φ in the range of -14° to -24°, θ in the range of -25° to -45° and ψ in the range of +8° to +28°,
and wherein an upper surface of the second resonance cavity comprises a physical and/or chemical modification as compared to an upper surface of the first resonance cavity, wherein the physical and/or chemical modification comprises a metallization layer or passivation layer formed on the upper surface of the second resonance cavity.

In particular, φ may be in the range of - 17° to -22°, θ in the range of -30° to -40° and ψ in the range of +10° to +25°, and more particularly, φ in the range of -19° to -21°, θ in the range of -33° to -39° and ψ in the range of +15° to +25°. Particularly, the angles for the crystal cut may be φ = -20°, θ = - 36° and ψ = 15° to 25°, in particular, 17°.

Note that the above definition is equivalent to angles φ in the range of +14° to +24°, θ in the range of -25° to -45° and ψ in the range of -8° to -28°, according to symmetry conditions for crystal cuts rotated around the Z axis (i.e. non zero φ and ψ angles for a given crystal cut). More explicitly, one can state according symmetry rules that a (YX*w*/*t*)/+φ/+θ/+ψ cut is equivalent to a (YX*w*/*t*)/-φ/+θ/-ψ cut.

The angles defining the crystal cut and, thus, the planar surface, are defined in accordance with the IEEE 176 1949 Standards on Piezoelectric Crystals, 1949 from 12-12-1949 (see also detailed description below). The quartz crystal may have a cutting plane (X", Z") defined with respect to the cutting plane (X, Z) and in a reference system (X", Y", Z"), where X, Y, Z are crystallographic axes of quartz, a direction of propagation of the waves being defined along an axis X"', a first cutting plane (X', Z') being defined by rotation by an angle φ about the axis Z of the plane (X, Z) so as to define a first reference system (X', Y', Z') with an axis Z' that is the same as the axis Z, a second cutting plane (X", Z") being defined by rotation by an angle θ about the axis X' of the plane (X', Z') so as to define a second reference system (X", Y", Z") with the axis X" being the same as the axis X', the direction of propagation along the axis X"' being defined by rotation by an angle ψ of the axis X", in the plane (X", Z") about the axis Y", wherein according to the present disclosure: φ is in the range of -14° to -24°, θ in the range of -25° to -45° and ψ in the range of +8° to +28°.

Experiments have shown that a quartz material layer for an acoustic wave sensor device resulting from such kind of crystal cut can provide low sensitivities to mechanical stresses and robustness of the measurement against environmental influences. A linear sensitivity of differential frequency sensitivities (linearity of temperature-frequency dependence) can be achieved. In fact, the obtainable resonance frequency sensitivity allows for a measurement sensitivity of more than 1 ppm per Kelvin in the context of temperature measurements by means of the provided acoustic wave sensor device. Variations of the second order temperature coefficient of differential frequency of 2 or even 1 ppb K⁻² can be achieved.

On the other hand, sensitivity to other parameters not related to the measurand, i.e., the residual stress sensitivity, can be reduced as compared to piezoelectric materials used for acoustic wave sensor devices of the art. In particular, the used crystal cut provides relative high reflection coefficients and electromechanical coupling for quartz and a constant wave velocity of the surface acoustic wave over a propagation direction range of 5° at minimum and even 10°.

The silicon substrate optionally comprises at its surface a so-called trap-rich layer (e.g. provided by a layer of polycrystalline silicon). The trap-rich layer allows reducing the insertion loss and reducing RF loss due to electric charge trapping induced at the interface with the silicon substrate. A sapphire substrate which is of high interest to maximize the quality factor of the resonance by minimizing the said visco-elastic losses in the substrate. Sapphire is known to be one of the most advantageous material according that aspect (with Ytrium based garnets and more particularly Ytrium Aluminum Garnet - YAG).

According to an embodiment at least one of the first and second reflection structures comprises or consists of a Bragg mirror (comprising elongated electrodes arranged in parallel to each other). Alternatively, at least one of the first and second reflection structures may comprise a groove or an edge reflection structure or a short reflector comprising not more than three electrodes. Such reflection structures may be easily formed and may provide high reflectivity. One skilled in the art would know how to adjust the depth of the groove or the thickness of the electrodes of the Bragg mirrors to provide a reflection coefficient in excess of, for example, 20 % which is achievable for a given crystal orientation, wave polarization and electrode nature.

The metalization layer may comprise or consist of at least one of AlCu and Ti and the passivation layer may comprise or consist, but is not limited to, of at least one of Si₃N₄, Al₂O₃, AIN, Ta₂O₅ and SiO₂. The metalization layer may be made of the same material as electrodes of the first transducer (and, thus, may be formed in the same processing step as the one used for forming the electrodes). If Bragg mirrors are used as reflection structures, they may be made of the same metal material as used for the formation of the metalization layer and/or the electrodes of the first transducer.

Another option for physically modifying an upper surface of the second resonance cavity comprises recessing the surface of the second resonance cavity with respect to the upper surface of the first resonance cavity.

An upper surface of the first resonance cavity may also be subject to a physical and/or treatment as described above but in a different manner as compared to the surface of the second resonance cavity.

The modification of one of the first and second upper surfaces of the resonance cavities by a metalization layer or passivation layer may result in that the propagation characteristics of acoustic waves generated by the interdigitated transducer differ in the second resonance cavity from the ones in the first resonance cavity. Thereby, a very reliable and sensitive differential sensor device may be provided. Without modification the first and second upper surfaces are free (exposed) surfaces, particularly, free surfaces of a quartz material layer piezoelectric layer.

In all of the above-described example the extension lengths of the first resonance cavity and the second resonance cavity may differ from each other in order to more clearly separate the spectral responses of the resonances of the first resonance cavity and the second resonance cavity from each other.

According to particular embodiments, in all of the above-described examples the interdigitated transducer may be split into two parts and the device may further comprise a third reflection structure (for example, a Bragg mirror) positioned between the two parts of the transducer. Such a configuration is particularly advantageous in operation situations in that the reflection coefficient of the transducer is not strong enough to allow for a clear enough separation between the resonances of the resonance cavities.

According to an embodiment the aperture of the first part of the interdigitated transducer is the same as the aperture of the second part of the interdigitated transducer and/or the is the same as the aperture of the second part of the interdigitated transducer and/or the metalization ratio of the first part of the interdigitated transducer is the same as the metalization ratio of the second part of the interdigitated transducer and/or the number of the electrodes and/or the lengths of the electrodes of the first part of the interdigitated transducer are the same as the number of the electrodes and/or the lengths of the electrodes of the second part of the interdigitated transducer. Both the first and the second part of the transducer may comprise tapered electrodes.

According to other embodiments, the first part of the interdigitated transducer comprises a first number of electrodes and the second part of the interdigitated transducer comprises a second number of electrodes and the first number of electrodes may be different from the second number. Additionally or alternatively, the lengths of at least some of the electrodes of the first number of electrodes may be different from the lengths of at least some of the electrodes of the second number of electrodes (i.e., the lengths of the two transducers in a direction perpendicular to the traveling direction of the surface acoustic waves). Further, the apertures of the first and second parts of the transducer may differ from each other. By such approaches, a fine tuning is made available in order to compensate for intrinsic losses caused by the metalization or passivation layer due to diffusion, wave velocity changes, change of optimal resonance conditions, etc.

Further, it is noted that, in principle, in other applications the first and second parts of the transducer may be considered as two individual transducers that are not operating in parallel to each other.

Moreover, cascaded resonance cavities may be formed in the acoustic wave sensor device according to one of the above-described embodiments in order to reduce the number of resonances to arrive at unique measurement results. Thus, the acoustic wave sensor device according to one of the above-described examples may be configured such that the first resonance cavity comprises first sub-cavities separated from each other by first reflection sub-structures of the first reflection structure and the second resonance cavity comprises second resonance sub-cavities separated from each other by second reflection sub-structures of the second reflection structure. Each of the reflection sub-structures may consist of elongated electrodes arranged in parallel to each other.

In general, the acoustic wave sensor device according to one of the above-described examples may be a passive surface acoustic wave sensor device configured for sensing an ambient parameter, for example, one of a temperature, chemical species, strain, pressure or torque of a rotating axis.

Furthermore, it is provided a system for monitoring/measuring an ambient parameter, for example, a temperature, a strain level, a pressure or a torque level of a rotating axis, a chemical species, etc. that comprises an interrogation device and an acoustic wave sensor device and/or acoustic wave sensor assembly according to one of the above-described embodiments which is communicatively coupled to the interrogation device.

The interrogation device for interrogating an acoustic wave sensor may comprise a transmission antenna configured for transmitting an RF interrogation signal to the acoustic wave sensor device, a reception antenna configured for receiving an RF response signal from the acoustic wave sensor device that may also comprise a transmission/reception antenna and a processing means for processing/analyzing the RF response signal in order to determine an ambient parameter that is to be sensed.

Additional features and advantages of the present invention will be described with reference to the drawings. In the description, reference is made to the accompanying figures that are meant to illustrate preferred embodiments of the invention. It is understood that such embodiments do not represent the full scope of the invention.
[Fig. 1] represents an example of a surface acoustic wave sensor device according to the art.
[Fig. 2] represents a principle sketch illustrating a surface acoustic wave sensor device comprising a transducer split into two parts and a central mirror located between the two parts of the transducer according to an embodiment of the present invention.
[Fig. 3] represents a principle sketch illustrating a surface acoustic wave sensor device according to the present invention.
[Fig. 4] represents an illustration of an embodiment of a surface acoustic wave sensor device comprising cascaded resonance cavities.
[Fig. 5] represents an illustration of a cascaded resonance cavity configuration of an acoustic wave sensor device wherein the transducer does not operate at the Bragg condition.
[Fig. 6] represents an illustration of another cascaded resonance cavity configuration of an acoustic wave sensor device wherein the transducer does not operate at the Bragg condition.
[Fig. 7] represents a principle sketch illustrating a combined acoustic wave pressure and temperature sensor device according to an embodiment of the present invention.
[Fig. 8] represents a principle sketch illustrating a combined acoustic wave pressure and temperature sensor device according to another embodiment of the present invention.
[Fig. 9] represents a sketch illustrating coordinates and angles of a piezoelectric plate
[Fig. 10] represents a sketch illustrating coordinates and angles of a triple-rotated crystal cut.

The present invention provides acoustic wave sensors, in particular, passive SAW sensors, that are characterized by a high signal-to-noise ratio, sensitivity and reliability, in particular, robustness against environmental influences and residual stresses not resulting from variations of the measurand, and high accuracy of differential measurements. These advantages are, particularly, achieved by using a piezoelectric quartz material layer providing resonance cavities that is characterized by a plane surface resulting from a crystal cut defined at angles φ in the range of -14° to -24°, θ in the range of -25° to -45° and ψ in the range of +8° to +28° according to the IEEE 176 1949 Standards on Piezoelectric Crystals, 1949 from 12-12-1949.

With respect to temperature measurements, for example, the obtainable resonance frequency sensitivity allows for a differential measurement sensitivity of more than 1 ppm per Kelvin. The acoustic wave sensors can be interrogated by any interrogators that are configured to determine a response spectrum from an interrogated acoustic wave sensor. The interrogated acoustic wave sensor can, for example, be a resonator device, for example, a differential SAW sensor. It goes without saying that the invention can be implemented in any devices employing acoustic wave sensors or dielectric resonators, RLC circuits, etc.

The interrogation device (also called unit) interrogating one of the inventive acoustic wave sensor devices may comprise a transmission antenna for transmitting an RF interrogation signal to the sensor device and a reception antenna for receiving a radiofrequency response signal from the sensor device. The radiofrequency interrogation signal transmitted by the transmission antenna may be generated by a signal generator that may comprise a radiofrequency synthesizer or controlled oscillator as well as optionally some signal shaping module providing a suitable frequency transposition and/or amplification of the signal to be transmitted by the transmission antenna. The radiofrequency interrogation signal generated by the signal generator may be a pulsed or burst signal with a frequency selected according to the resonance frequency of the acoustic wave sensor device. It is noted that the emission antenna and the reception antenna may be the same antenna. In this case, the emission and reception processes should be synchronized with each other, for example, by means of a suitably controlled switch.

Furthermore, the interrogation device may comprise a processing means connected to the reception antenna. The processing means may comprise filtering and/or amplification means and be configured for analyzing the RF response signal received by the reception antenna. For example, the sensor device operates at a resonance frequency of 434 MHz or 866 MHz or 915 MHz or 2.45 GHz (the said ISM bands).

The interrogation device may transmit a long RF pulse and after the transmission has been stopped, the resonance cavities of the sensor device discharge at their resonant eigen-frequencies with time constants τ equal to Q_{f}/πF wherein F is the central frequency and Q_{f} is the quality factor of the resonance, Q_{f} corresponding to the ratio between the resonance central frequency and the width at half maximum of the band pass used in the interrogation process. For instance, Q_{f} corresponds to the resonance quality factor estimated on the real part of the resonator admittance (the said conductance) when the latter is designed to operate at said resonance. Spectral analysis performed by the processing means of the interrogation device allows for calculating the resonator frequency/frequencies and, thereby, the sensing of an ambient parameter. The received RF response signal may be mixed by the processing means with RF interrogation signal according to the so-called I-Q protocol as known in the art to extract the real and imaginary parts (in-phase components I = Y cos φ and quadrature components Q = Y sin φ with the signal amplitude Y and the signal phase φ) from which the modulus and phase can then be derived.

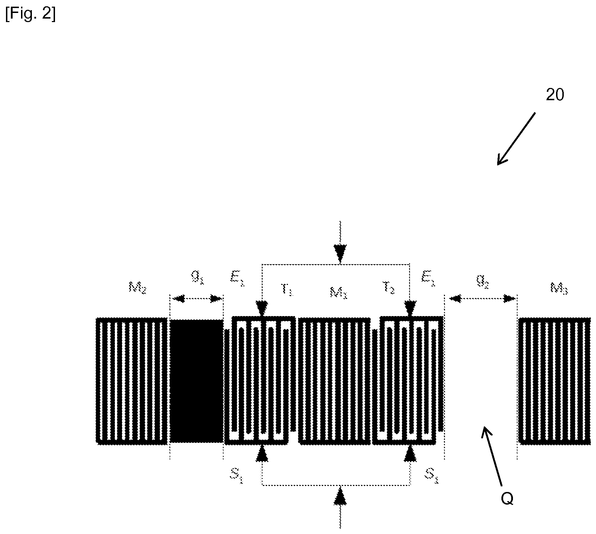

Figure 2 illustrates an exemplary embodiment of an inventive surface acoustic wave (SAW) sensor device 20. The sensor device 20 shown in Figure 2 as well as the sensor devices described below are formed using a quartz material layer Q as a piezoelectric layer. The quartz material layer Q may be a quartz bulk substrate, Alternatively, the quartz layer Q may be formed over some non-piezoelectric bulk substrate, for example, a Si substrate, i.e., the quartz material layer Q may be part of a piezo-electric-on-insulator (POI) substrate. The quartz layer may be bonded to the non-piezoelectric bulk substrate by means of a (dielectric) bonding layer, as for instance a silicon oxide layer. A so-called trap-rich layer (e.g. polycrystalline silicon) can be present at the interface with the non-piezoelectric bulk substrate.

In the embodiment shown in Figure 2 as well as the other embodiments described below the quartz material layer Q comprises an upper operating planar surface and the planar surface of the quartz material layer Q is defined by a crystal cut of a quartz material of the quartz material layer with angles φ in the range of -14° to -24°, θ in the range of -25° to -45° and ψ in the range of +8° to +28°, the angles being defined in accordance with the IEEE 176 1949 Standards on Piezoelectric Crystals, 1949 from 12-12-1949. It is this particular cut family that provides the advantages mentioned and described above.

A SAW sensor device according to an embodiment of the present invention, for example, the SAW sensor device 20 shown in Figure 2, comprises a transducer. In the embodiment shown in Figure 2 the transducer is split into a first part T1 and a second part T2 (or a first transducer T1 and a second transducer T2). The transducers T1 and T2 may be interdigitated (comb) transducers connected to an antenna (not shown in Figure 2) for receiving an electromagnetic wave and converting the electromagnetic wave into a surface acoustic wave. In fact, the first and second parts of the transducer T1 and T2 operate in parallel (thereby functioning as one single transducer) and receive an electromagnetic wave E1 and convert the received electromagnetic wave E1 into a surface acoustic wave which after reflection by the mirrors is sensed again by the two parts of the transducer T1 and T2 and converted back into an RF signal S1. The back-converted acoustic wave is in course transmitted by the antenna (or another antenna) as an RF response signal.

In the shown example, the first part of the transducer T1 and the second part of the transducer T2 share one Bragg mirror structure M1 that is positioned between them. The surface acoustic wave sensor device 20 comprises a second Bragg mirror structure M2 that is separated from the first part of the transducer T1 by a resonance cavity of the length g1. Further, the surface acoustic wave sensor device 20 comprises a third Bragg mirror structure M3 that is separated from the second part of the transducer T2 by a resonance cavity of the length g2 > g1. It should be noted that, in principle, the two resonance cavities may have the same lengths or g1 < g2 may hold. Changing the length of one of the resonance cavities translates to locally modifying the wave propagation conditions of the generated surface acoustic waves.

The surface acoustic wave sensor 20 (as well as the devices described below with reference to other ones of the Figures) may operate at Bragg conditions with wavelengths of the excited surface acoustic waves of some multiples of the pitches of the comb electrodes of the comb transducer. When operation is performed at Bragg conditions the comb transducer itself substantially functions as a mirror. However, in operation situations in that the reflection coefficient of the transducer is not strong enough to allow for a clear enough separation between the individual resonance cavities it is advantageous to split the transducer into the two parts T1 and T2 and arrange a mirror M1 between them as shown in Figure 2. Improving the cavity resonance separation by means of the split transducer and the additional mirror is particularly useful for operating with Rayleigh or more generally elliptically polarized waves.

It is noted that the electrodes of the first and second parts T1 and T2 of the transducer may be made of or comprise Al or AlCu. The use of materials with relatively high atomic numbers like, for instance, molybdenum or gold or platinum or tantalum or tungsten may allow for larger reflection coefficients. In that case, the need for an additive mirror in between the gap of the split transducer as well as the transducer split itself may not be required anymore.

For the sake of electrical response optimization, the first and second parts T1 and T2 of the transducer may exhibit different lengths (perpendicular to the traveling direction of the surface waves) and/or apertures as the two resonance cavities with different surface conditions exhibit different physical properties which may yield to unbalanced contributions of the corresponding modes to the sensor electrical responses. For example, a metalized resonance cavity may exhibit more losses (due to the metal properties itself or the degradation of surface roughness for instance) than a resonance cavity with a free surface. Therefore, it may be useful to increase the length of one of the two parts of the transducers to compensate for enhanced losses in the corresponding cavity and therefore provide balanced contributions of the resonance modes. However, this approach may also substantially modify the overall electrical response of the sensor, actually loading the transducer which does not suffer from the additional leakage caused by the physical and/or chemical modification with some static capacitance of the modified transducer. In this context, one might reduce the aperture of the modified transducer to benefit from the extended length yielding an enhanced signal strength and narrower transducer bandwidth and control its static capacitance to preserve the electrical sensor response. In that situation, the central mirror may actually exhibit the acoustic aperture of the largest of the two transducers to guarantee an optimal acoustic operation on both sides of the sensor device 20.

The mirror gratings of the second Bragg mirror structure M2 and of the third Bragg mirror structure M3 may differ from each other and may be suitably adapted to result in optimum resonance conditions.

According to the embodiment illustrated in Figure 2, the upper surface of the resonance cavity with length g1 comprises a physical and/or chemical modification as compared to the upper surface of the resonance cavity with length g2. Alternatively, the upper surface of the resonance cavity with length g2 could comprise a physical and/or chemical modification as compared to the upper surface of the resonance cavity with length g1. However, no surface modification may be present in other alternative embodiments.

There is a variety of means for providing the physical and/or chemical modifications in order to achieve propagating wave modes that exhibit differential parametric sensitivities. These means, for example, include realization of the physical and/or chemical modifications by the formation of a metalization layer and/or passivation layer. A metalization layer of some 100 nm thickness may be formed on the region of the resonance cavity of length g1, for example; no metalization layer may be formed on the resonance cavity of length g2. The metalization layer may be formed of the same material as the electrodes of the transducer T and/or the Bragg mirror structure M1 and/or the Bragg mirror structure M2.

When the same material is used for the metalization and the formation of the comb transducer T and electrodes of the Bragg mirror structures M1 and M2, all of these elements can be deposited in the same deposition process. In other embodiments a different material is used for the metalization. For example, one metalization layer or passivation layer of one material is formed on the first resonance cavity of length g1 and another metalization layer or passivation layer of another material is formed on the second resonance cavity of length g2. According to another example, a positive-temperature shifting material, for example, SiO₂ or Ta₂O₅, is formed on one of the resonance cavities and a negative-temperature shifting material, for example, Si₃N₄ or AIN, or no additional material is formed on the other one of the resonance cavities.

Passivation may be realized by forming a passivation layer made of or comprising Si₃N₄, Al₂O₃ or AIN. According to other embodiments, material layers can be formed on both resonance cavities. Moreover, material layers formed on one or more of the resonance cavities may have inhomogeneous thicknesses along the direction of propagation of the acoustic waves. Further, multi-layers may be formed on one or more of the resonance cavities. In this context, it should be noted that, in general, provision of a material layer on a resonance cavity may result in a reduction of the phase velocity of acoustic waves due to mass loading effects, particularly, if layers of a material of a high atomic number, as Pt, Au or W, are used. This effect can be compensated by adding a layer exhibiting a relatively high acoustic velocity, for example, AIN, Si₃N₄, Al₂O₃, adjacent to the quartz material layer. The resonance cavities exhibit different sensitivities to measurands due to the provided different resonance characteristics caused by different treatments of the surfaces and, thus, allow for differential measurements.

Alternatively or additionally, the physical and/or chemical modification may comprise a recess of the surface of the resonance cavity with length g1 with respect to the surface of the resonance cavity with length g2. Such kind of modification may be particularly advantageous for a POI substrate with a piezoelectric layer of a thickness that is less than one wavelength of the generated acoustic wave. According to further embodiments the resonance cavity with length g1 comprises another physical and/or chemical modification that is different from the one of the resonance cavity with length g2. All combinations of the named modifications are envisaged as long as the modifications of the surfaces of the cavities differ from each other in order to guarantee different resonance characteristics of the resonance cavities. It has to be understood that the thus described surface modification of a resonance cavity can be provided for any of the embodiments disclosed herein.

It is, furthermore, noted that the configuration of the sensor device 20 shown in Figure 2 may comprise tapered transducers with lateral extensions of the electrodes (perpendicular to the direction of propagation of the generated acoustic waves) varying along the lengths of the transducers in order to suppress transverse modes of the acoustic waves. For the same purpose, some mass loads may be provided at the edges of the electrodes.

In the above-described embodiment, Bragg mirrors are provided in order to form the resonance cavities. However, according to alternative embodiments one or more of the Bragg mirrors may be replaced by side/edge reflection structures for pure shear mode guidance both in the configuration shown in Figure 2 and the embodiments described below. Thereby, very compact configurations can be achieved in that the Bragg reflection is replaced by a flat surface reflection without any energy loss or mode conversion. Configurations with side/edge reflection structures for pure shear mode guidance are particularly useful for sensing ambient parameters in liquids. Shear waves are very suitable for in-liquid probing. Particularly, highly coupled modes (> 5%) together with high-k materials (with a dielectric constant k larger than 30, for example) are attractive for in-liquid applications. According to other embodiments, one or more reflection structures are realized in the form of short reflectors comprising not more than three electrodes.

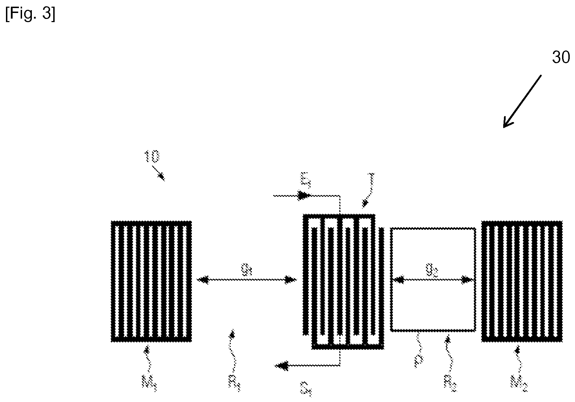

Figure 3 shows another embodiment of a SAW sensor device 30. The SAW sensor device 30 comprises an interdigitated transducer T connected to an antenna (not shown in Figure 3) for receiving an electromagnetic wave E₁ and converting the electromagnetic wave E₁ into a surface acoustic wave. The comb transducer T comprises interdigitated electrodes. Two SAW resonance cavities R₁ and R₂ with extensions (gaps) g₁ and g₂, respectively, are provided between the comb transducer T and Bragg mirrors M₁ and M₂, respectively. Thus, different from the embodiment shown in Figure 2 the transducer T is not split into two parts (parts T1 and T2 shown in Figure 2). The transducer may show a 40 λ acoustic aperture. The description of all other features made with reference to the configuration shown in Figure 2 also holds for the configuration shown in Figure 3.

In the above-described embodiments that comprise Bragg mirrors, simple resonance cavities are employed. However, these embodiments may, alternatively, employ cascaded resonance cavities comprising multiple mirror electrode structures. The spectral distance between the two resonances as well as the coupling coefficient of the resonances can be controlled by the number of the mirror electrode structures and resonance sub-cavities.

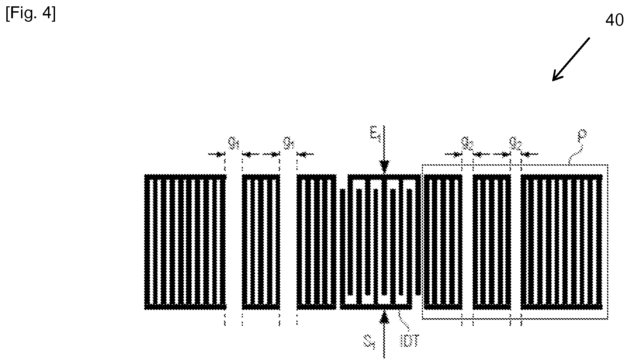

An exemplary embodiment of an acoustic wave sensor 40 comprising cascaded resonance cavities is shown in Figure 4. In this embodiment three-mirror electrode structures separated by gaps g₁ and g₂ resulting in resonance sub-cavities are provided on each side of the IDT. Different widths of the cavities g₁ and g₂ may result in a limitation of the number of 50 Ω matched resonances to only two which is different to more than two resonances that arise in the previously described embodiments. The distance between the two resonances as well as the coupling coefficient of the resonances can be controlled by the number of the mirror electrode structures and resonance sub-cavities.

In the case of using cascaded resonator cavities, it is possible to use a transducer which does not operate at the Bragg condition. For instance, the transducer may exhibit three or four fingers per wavelength or even 5 fingers per two wavelengths and in general all suitable structures that allow exciting waves at a given synchronism without wave reflection on the IDT electrodes.

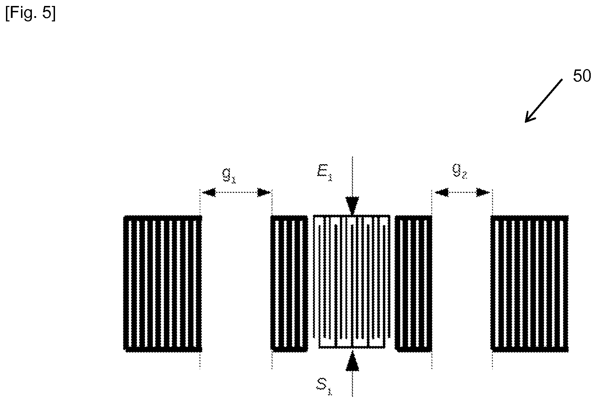

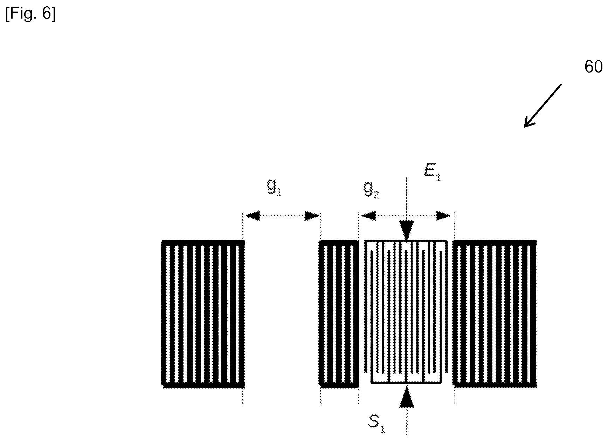

Two examples for possible configurations in this respect are shown in Figures 5 and 6. According to one configuration (see Figure 5) an acoustic wave sensor 50 comprises smaller mirrors that are arranged close to the transducer and larger mirrors separated by distances g₁ and g₂, respectively, from the smaller mirrors are additionally provided to guarantee resonances in the resonance cavities. Figure 6 illustrates a configuration of an acoustic wave sensor 60 for which on the-left-hand side no Bragg condition is fulfilled for the operation of the transducer. One or more of the resonance cavities may be physically and/or chemically modified as it is described above. It is worth noting that in the examples shown in Figures 5 and 6, some supplementary resonances are established in the IDT region itself, i.e., the IDT operates as a supplementary cavity which could potentially be used to complete the measurements.

In general, the acoustic wave sensor device according to each of the above-described examples may be a passive surface acoustic wave sensor device configured for sensing an ambient parameter, for example, one of a temperature, chemical species, strain, pressure or torque of a rotating axis.

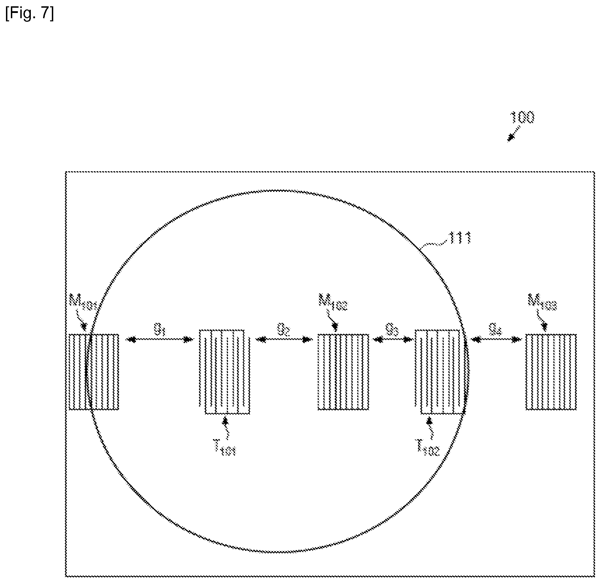

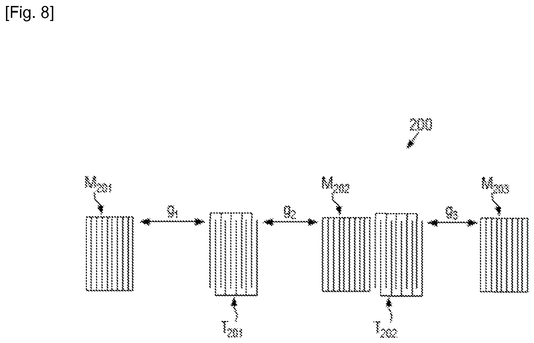

A single acoustic wave sensor device according to the above-described embodiments may be supplemented by one or more additional acoustic wave sensor devices. For example, thereby combined acoustic wave pressure and temperature sensor devices can be realized as it is exemplarily illustrated in Figures 7 and 8. The combined acoustic wave pressure and temperature sensor device 100 shown in Figure 7 comprises a first transducer T101 of a first sensor device and a second transducer T102 of a second sensor device. In principle, the second transducer T102 may be part of both the first and the second sensor device. The transducers T101 and T102 may be interdigitated (comb) transducers connected to an antenna for receiving an electromagnetic wave and converting the electromagnetic wave into a surface acoustic wave.

The second sensor device comprising the second transducer T102 is configured for sensing an ambient temperature. The first sensor device comprising the first transducer T101 is configured for sensing a pressure in accordance with the above-described embodiments. Additionally, the first sensor device may be also configured for sensing the ambient temperature. In this case, with respect to the sensing of the ambient temperature the first and second sensor devices constitute a differential acoustic wave temperature sensor device.

The first sensor device comprises a first Bragg mirror structure M101 that is separated from the first transducer T101 by a first resonance cavity of the length g1. Furthermore, the first sensor device comprises a second Bragg mirror structure M102 that is separated from the first transducer T101 by a second resonance cavity of the length g2. The first sensor device may comprise a single transducer. Alternatively, it may comprise the configuration with two transducers and a central additional Bragg mirror located between the two transducers as described with reference to Figure 2. The second sensor device comprises a third Bragg mirror structure M103 that is separated from the second transducer T102 by a third resonance cavity of the length g3 that may or may not differ from the lengths g1 and/or g2 of the first and second cavities, respectively. All these structures may be formed on/over a quartz material substrate 111 resulting from the above-described crystal cut.

Another cavity with a length g4 is formed between the second Bragg mirror structure M102 and the second transducer T102.The cavity with the length g4 as well as the third Bragg mirror structure M103 of the second sensor device are not formed on the above-described quartz material layer or quartz material substrate 111 that is subject to the above-described bending when some external pressure is applied.

In particular, the upper surface of the first resonance cavity with length g1 and/or the upper surface of the resonance cavity with length g2 may or may not comprise some surface modification as it was described above.

Without modification the first and second upper surfaces are free (exposed) surfaces, particularly, free surfaces of a piezoelectric layer of the combined acoustic wave pressure and temperature sensor device.

Figure 8 shows an alternative configuration to the one illustrated in Figure 7. As compared to the configuration illustrated in Figure 7 according to the embodiment shown in Figure 8 the combined acoustic wave pressure and temperature sensor device 200 comprises only three rather than four cavities.

The combined sensor device 200 shown in Figure 8 comprises a first transducer T201 of a first sensor device and a second transducer T202 of a second sensor device. The second sensor device comprising the second transducer T202 is configured for sensing an ambient temperature. The transducers T201 and T202 may be interdigitated (comb) transducers connected to an antenna for receiving an electromagnetic wave and converting the electromagnetic wave into a surface acoustic wave. The first sensor device comprising the first transducer T201 is configured for sensing a pressure in accordance with the above-described embodiments. Additionally, the first sensor device may be also configured for sensing the ambient temperature. In this case, with respect to the sensing of the ambient temperature the first and second sensor devices constitute a differential acoustic wave temperature sensor device.

The first sensor device comprises a first Bragg mirror structure M201 that is separated from the first transducer T201 by a first resonance cavity of the length g1. Furthermore, the first sensor device comprises a second Bragg mirror structure M202 that is separated from the first transducer T201 by a second resonance cavity of the length g2. The first sensor device of the combined acoustic wave pressure and temperature sensor device 200 may comprise a single transducer. Alternatively, it may comprise the configuration with two transducers and a central additional Bragg mirror located between the two transducers as described with reference to Figure 2. The second sensor device comprises a third Bragg mirror structure M203 that is separated from the second transducer T202 by a third resonance cavity of the length g3 that may or may not differ from the lengths g1 and/or g2 of the first and second cavities, respectively. According to the embodiment shown in Figure 8 the combined sensor device 200 comprises no resonance cavity between the second Bragg mirror structure M202 and the second transducer T202.

The cavity with the length g3 as well as the third Bragg mirror structure M203 of the second sensor device are not formed on the above-described quartz material layer that is subject to the above-described bending. The sensor device 200 shown in Figure 8 may, furthermore, comprise a supporting substrate, lid and/or seals as known in the art.

Again, the upper surface of the first resonance cavity with length g1 and/or the upper surface of the resonance cavity with length g2 may or may not comprise some surface modification as it was described above.

All previously discussed embodiments are not intended as limitations but serve as examples illustrating features and advantages of the invention. It is to be understood that some or all of the above described features can also be combined in different ways.

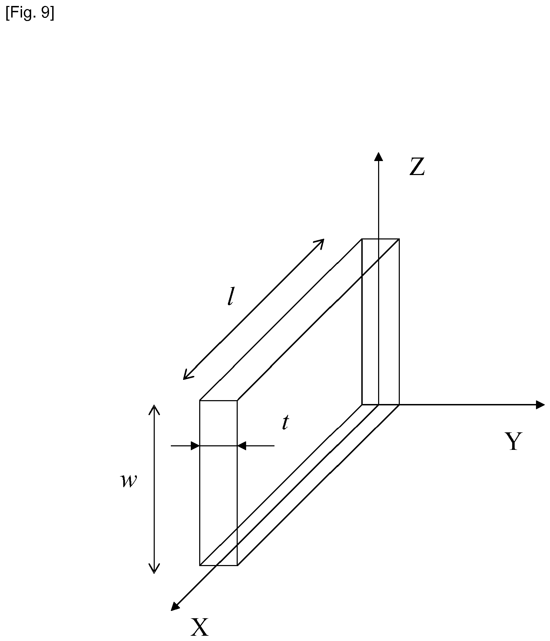

In the present disclosure, crystal cuts are defined in accordance with the IEEE 176 1949 Standards on Piezoelectric Crystals, 1949 from 12-12-1949. In that standard, a crystal cut for SAW applications is uniquely defined by three angles, namely φ and θ defining the rotation of the crystal according a reference configuration of the said crystal and ψ a propagation direction defined in the plane (φ, θ) that indicates the direction toward which the waves are propagating and hence the position of the transducer capable to launch the said waves. Y and X denote crystalline axes considered as references for the definition of the initial state of the crystal plate. The first one is the axis normal to the said plate whereas the second axis lies along the length of the plate. The plate is assumed to be rectangular, characterized by its length *I*, its width w and its thickness *t* (see Figure 9). The length *I* is lying along the crystalline axis X, the width w is along the Z axis and the thickness t along the Y axis considering the given (YX) axis system. Note that the case of (YX*w*/*t*)/0°/0°/0° actually coincides to the configuration shown in Figure 9.

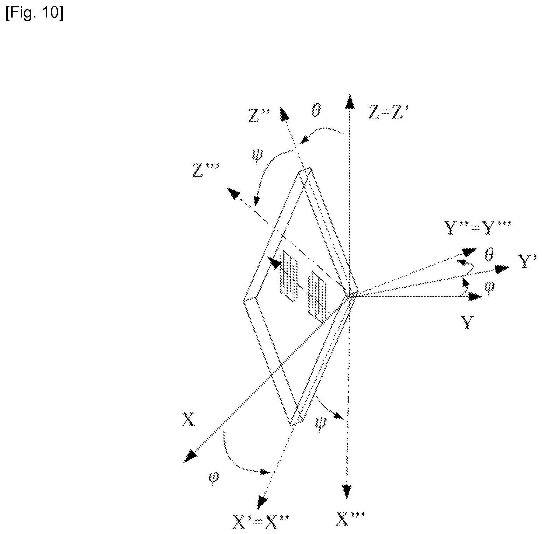

Assuming now that none of the angles is zero, we consider the general case of a triple-rotation or triply-rotated cut. In that situation, the quartz crystal has a cutting plane (X", Z") defined with respect to the cutting plane (X, Z) and in a reference system (X", Y", Z"), where X, Y, Z are crystallographic axes of quartz, a direction of propagation of the waves being defined along an axis X'", a first cutting plane (X', Z') being defined by rotation by an angle φ about the axis Z of the plane (X, Z) so as to define a first reference system (X', Y', Z') with an axis Z' that is the same as the axis Z, a second cutting plane (X", Z") being defined by rotation by an angle θ about the axis X' of the plane (X', Z') so as to define a second reference system (X", Y", Z") with the axis X" being the same as the axis X', the direction of propagation along the axis X'" being defined by rotation by an angle ψ of the axis X", in the plane (X", Z") about the axis Y", as shown in Figure 10.

Some symmetry rules are recalled hereafter for quartz. Quartz is a trigonal crystal of class 32. Therefore, it is characterized by a ternary axis, i.e. the Z axis around which one can establish the relation: $\left(YXw\right) / φ = \left(YXw\right) / φ + 120 °$

The two other axes are binary and therefore the following symmetry relations hold: $\left(YXl\right) / θ = \left(YXl\right) / θ + 180 ° , \left(YXt\right) / ψ = \left(YXt\right) / ψ + 180 °$

For simple geometrical reasons, it is easy to demonstrate that the following set of axes are equivalent: $\left(YXw/t\right) / + φ / + θ / + ψ = \left(YXw/t\right) / - φ / + θ / - ψ$

Actually, assuming that the upper face is identified by the plus sign for φ (the face where the surface wave is assumed to propagate), the bottom face of the plate is obtained by changing the sign to minus. Considering that the symmetry operation does not change the sign of ψ one would assume that the direction of Z"' on the bottom side is unchanged but actually it is rotated by 180°. Therefore, to recover the top surface situation, it is mandatory to apply a 180° rotation on ψ which actually is equivalent to a sign change. Note that for crystal cuts without rotation around Z (φ=0°), the following symmetry is effective: (YX/*t*)/+θ/+ψ = (YX/*t*)/+θ/-ψ.

## Claims

1. Acoustic wave sensor device (20, 30, 40, 50, 60, 100, 200), comprising
a Si bulk substrate or a sapphire bulk substrate;
a quartz material layer comprising a planar surface and formed over the Si bulk substrate or the sapphire bulk substrate;
a first interdigitated transducer (T) formed over the planar surface of the quartz material layer;
a first reflection structure (M1, M101, M102) formed over the planar surface of the quartz material layer;
a second reflection structure (M2, M102, M202) formed over the planar surface of the quartz material layer;
a first resonance cavity (R1) formed between the first interdigitated transducer (T) and the first reflection structure (M1, M101, M102); and
a second resonance cavity (R2) formed between the first interdigitated transducer (T) and the second reflection structure (M2, M102, M202);
wherein
the planar surface of the quartz material layer is defined by a crystal cut of a quartz material of the quartz material layer with angles φ in the range of -14° to - 24°, θ in the range of -25° to -45° and ψ in the range of +8° to +28°;
and wherein an upper surface of the second resonance cavity (R2) comprises a physical and/or chemical modification as compared to an upper surface of the first resonance cavity (R1), wherein the physical and/or chemical modification comprises a metallization layer or passivation layer formed on the upper surface of the second resonance cavity (R2).

2. The acoustic wave sensor device (20, 30, 40, 50, 60, 100, 200) according to claim 1, wherein at least one of the first and second reflection structures (M1, M101, M102, M2, M102, M202) comprises or consists of a Bragg mirror.

3. The acoustic wave sensor device (20, 30, 40, 50, 60, 100, 200) according to claim 1 or 2, wherein at least one of the first and second reflection structures (M1, M101, M102, M2, M102, M202) comprises a groove or an edge reflection structure or a short reflector comprising not more than three electrodes.

4. The acoustic wave sensor device (20, 30, 40, 50, 60, 100, 200) according to one of the preceding claims, wherein the extensions lengths of the first resonance cavity (R1) and the second resonance cavity (R2) differ from each other.

5. The acoustic wave sensor device (20, 30, 40, 50, 60, 100, 200) according to one of the preceding claims, wherein the interdigitated transducer (T) is split into two parts (T1, T2, T101, T102, T201, T202) and further comprising a third reflection structure positioned between the two parts of the interdigitated transducer.

6. The acoustic wave sensor device (20, 30, 40, 50, 60, 100, 200) according to claim 5, wherein the third reflection structure is a Bragg mirror.

7. The acoustic wave sensor device (20, 30, 40, 50, 60, 100, 200) according to claim 5 or 6, wherein a length of one of the two parts of the interdigitated transducer differs from a length of the other one of the two parts and/or an aperture of one of the two parts of the interdigitated transducer differs from an aperture of the other one of the two parts of the interdigitated transducer.

8. The acoustic wave sensor device (20, 30, 40, 50, 60, 100, 200) according to one of the preceding claims, wherein the first resonance cavity comprises first resonance sub-cavities separated from each other by first reflection sub-structures of the first reflection structure and the second resonance cavity comprises second resonance sub-cavities separated from each other by second reflection sub-structures of the second reflection structure.

9. The acoustic wave sensor device (20, 30, 40, 50, 60, 100, 200) according to one of the preceding claims, wherein the acoustic wave sensor device (20, 30, 40, 50, 60, 100, 200) is a passive surface acoustic wave sensor device (20, 30, 40, 50, 60, 100, 200) configured for sensing an ambient parameter selected from one of a temperature, chemical species, strain, pressure or torque of a rotating axis.

## Patentansprüche

1. Akustikwellen-Sensorvorrichtung (20, 30, 40, 50, 60, 100, 200), umfassend
ein Si-Volumensubstrat oder ein Saphir-Volumensubstrat;
eine Quarzmaterialschicht, die eine planare Oberfläche umfasst und auf dem Si-Volumensubstrat oder dem Saphir-Volumensubstrat ausgebildet ist;
einen ersten Interdigitalwandler (T), der auf der planaren Oberfläche der Quarzmaterialschicht ausgebildet ist;
eine erste Reflexionsstruktur (M1, M101, M102), die auf der planaren Oberfläche der Quarzmaterialschicht ausgebildet ist;
eine zweite Reflexionsstruktur (M2, M102, M202), die auf der planaren Oberfläche der Quarzmaterialschicht ausgebildet ist;
eine erste Resonanzkavität (R1), die zwischen dem ersten Interdigitalwandler (T) und der ersten Reflexionsstruktur (M1, M101, M102) ausgebildet ist; und
eine zweite Resonanzkavität (R2), die zwischen dem ersten Interdigitalwandler (T) und der zweiten Reflexionsstruktur (M2, M102, M202) ausgebildet ist;
wobei die planare Oberfläche der Quarzmaterialschicht durch einen Kristallschnitt eines Quarzmaterials der Quarzmaterialschicht mit Winkeln φ im Bereich von -14° bis -24°, θ im Bereich von -25° bis -45° und ψ im Bereich von +8° bis +28° definiert ist;
und wobei eine obere Oberfläche der zweiten Resonanzkavität (R2) eine physikalische und/oder chemische Modifikation gegenüber einer oberen Oberfläche der ersten Resonanzkavität (R1) umfasst, wobei die physikalische und/oder chemische Modifikation eine Metallisierungsschicht oder Passivierungsschicht umfasst, die auf der oberen Oberfläche der zweiten Resonanzkavität (R2) ausgebildet ist.

2. Akustikwellen-Sensorvorrichtung (20, 30, 40, 50, 60, 100, 200) nach Anspruch 1, wobei mindestens eine der ersten und zweiten Reflexionsstrukturen (M1, M101, M102, M2, M102, M202) einen Bragg-Spiegel umfasst oder aus einem solchen besteht.

3. Akustikwellen-Sensorvorrichtung (20, 30, 40, 50, 60, 100, 200) nach Anspruch 1 oder 2, wobei mindestens eine der ersten und zweiten Reflexionsstrukturen (M1, M101, M102, M2, M102, M202) eine Nut oder eine Kantenreflexionsstruktur oder einen kurzen Reflektor umfasst, der nicht mehr als drei Elektroden umfasst.

4. Akustikwellen-Sensorvorrichtung (20, 30, 40, 50, 60, 100, 200) nach einem der vorhergehenden Ansprüche, wobei die Längen der Erstreckungen der ersten Resonanzkavität (R1) und der zweiten Resonanzkavität (R2) voneinander verschieden sind.

5. Akustikwellen-Sensorvorrichtung (20, 30, 40, 50, 60, 100, 200) nach einem der vorhergehenden Ansprüche, wobei der Interdigitalwandler (T) in zwei Teile (T1, T2, T101, T102, T201, T202) aufgeteilt ist und ferner umfassend eine dritte Reflexionsstruktur, die zwischen den zwei Teilen des Interdigitalwandlers angeordnet ist.

6. Akustikwellen-Sensorvorrichtung (20, 30, 40, 50, 60, 100, 200) nach Anspruch 5, wobei die dritte Reflexionsstruktur ein Bragg-Spiegel ist.

7. Akustikwellen-Sensorvorrichtung (20, 30, 40, 50, 60, 100, 200) nach Anspruch 5 oder 6, wobei eine Länge eines der zwei Teile des Interdigitalwandlers sich von einer Länge des anderen der zwei Teile unterscheidet und/oder eine Apertur eines der zwei Teile des Interdigitalwandlers sich von einer Apertur des anderen der zwei Teile des Interdigitalwandlers unterscheidet.

8. Akustikwellen-Sensorvorrichtung (20, 30, 40, 50, 60, 100, 200) nach einem der vorhergehenden Ansprüche, wobei die erste Resonanzkavität erste Resonanz-Unterkavitäten umfasst, die durch erste Reflexions-Unterstrukturen der ersten Reflexionsstruktur voneinander getrennt sind, und die zweite Resonanzkavität zweite Resonanz-Unterkavitäten umfasst, die durch zweite Reflexions-Unterstrukturen der zweiten Reflexionsstruktur voneinander getrennt sind.

9. Akustikwellen-Sensorvorrichtung (20, 30, 40, 50, 60, 100, 200) nach einem der vorhergehenden Ansprüche, wobei die Akustikwellen-Sensorvorrichtung (20, 30, 40, 50, 60, 100, 200) eine passive Sensorvorrichtung für akustische Oberflächenwellen (20, 30, 40, 50, 60, 100, 200) ist, die zum Erfassen eines Umgebungsparameters konfiguriert ist, der aus einem von einer Temperatur, chemischen Spezies, Dehnung, Druck oder Drehmoment einer rotierenden Achse ausgewählt ist.

## Revendications

1. Dispositif capteur d'ondes acoustiques (20, 30, 40, 50, 60, 100, 200), comprenant
un substrat massif en Si ou un substrat massif en saphir ;
une couche de matériau de quartz comprenant une surface plane et formée sur le substrat massif en Si ou le substrat massif en saphir ;
un premier transducteur interdigité (T) formé sur la surface plane de la couche de matériau de quartz ;
une première structure de réflexion (M1, M101, M102) formée sur la surface plane de la couche de matériau de quartz ;
une deuxième structure de réflexion (M2, M102, M202) formée sur la surface plane de la couche de matériau de quartz ;
une première cavité de résonance (R1) formée entre le premier transducteur interdigité (T) et la première structure de réflexion (M1, M101, M102) ; et
une deuxième cavité de résonance (R2) formée entre le premier transducteur interdigité (T) et la deuxième structure de réflexion (M2, M102, M202) ;
dans lequel la surface plane de la couche de matériau de quartz est définie par une coupe cristalline d'un matériau de quartz de la couche de matériau de quartz avec des angles φ dans la plage de -14° à -24°, θ dans la plage de -25° à -45° et ψ dans la plage de +8° à +28° ;
et dans lequel une surface supérieure de la deuxième cavité de résonance (R2) comprend une modification physique et/ou chimique par rapport à une surface supérieure de la première cavité de résonance (R1), dans lequel la modification physique et/ou chimique comprend une couche de métallisation ou couche de passivation formée sur la surface supérieure de la deuxième cavité de résonance (R2).

2. Dispositif capteur d'ondes acoustiques (20, 30, 40, 50, 60, 100, 200) selon la revendication 1, dans lequel au moins l'une des première et deuxième structures de réflexion (M1, M101, M102, M2, M102, M202) comprend ou est constituée d'un miroir de Bragg.

3. Dispositif capteur d'ondes acoustiques (20, 30, 40, 50, 60, 100, 200) selon la revendication 1 ou 2, dans lequel au moins l'une des première et deuxième structures de réflexion (M1, M101, M102, M2, M102, M202) comprend une rainure ou une structure de réflexion de bord ou un réflecteur court comprenant au plus trois électrodes.

4. Dispositif capteur d'ondes acoustiques (20, 30, 40, 50, 60, 100, 200) selon l'une des revendications précédentes, dans lequel les longueurs des extensions de la première cavité de résonance (R1) et de la deuxième cavité de résonance (R2) diffèrent l'une de l'autre.

5. Dispositif capteur d'ondes acoustiques (20, 30, 40, 50, 60, 100, 200) selon l'une des revendications précédentes, dans lequel le transducteur interdigité (T) est divisé en deux parties (T1, T2, T101, T102, T201, T202) et comprenant en outre une troisième structure de réflexion positionnée entre les deux parties du transducteur interdigité.

6. Dispositif capteur d'ondes acoustiques (20, 30, 40, 50, 60, 100, 200) selon la revendication 5, dans lequel la troisième structure de réflexion est un miroir de Bragg.

7. Dispositif capteur d'ondes acoustiques (20, 30, 40, 50, 60, 100, 200) selon la revendication 5 ou 6, dans lequel une longueur de l'une des deux parties du transducteur interdigité diffère d'une longueur de l'autre des deux parties et/ou une ouverture de l'une des deux parties du transducteur interdigité diffère d'une ouverture de l'autre des deux parties du transducteur interdigité.

8. Dispositif capteur d'ondes acoustiques (20, 30, 40, 50, 60, 100, 200) selon l'une des revendications précédentes, dans lequel la première cavité de résonance comprend des premières sous-cavités de résonance séparées les unes des autres par des premières sous-structures de réflexion de la première structure de réflexion et la deuxième cavité de résonance comprend des deuxièmes sous-cavités de résonance séparées les unes des autres par des deuxièmes sous-structures de réflexion de la deuxième structure de réflexion.

9. Dispositif capteur d'ondes acoustiques (20, 30, 40, 50, 60, 100, 200) selon l'une des revendications précédentes, dans lequel le dispositif capteur d'ondes acoustiques (20, 30, 40, 50, 60, 100, 200) est un dispositif capteur passif à ondes acoustiques de surface (20, 30, 40, 50, 60, 100, 200) configuré pour détecter un paramètre ambiant sélectionné parmi l'un d'une température, d'une espèce chimique, d'une déformation, d'une pression ou d'un couple d'un axe rotatif.
